# EUROPEAN PATENT SPECIFICATION

(11) **EP 3 024 143 B1**
(45) Date of publication and mention of the grant of the patent: **05.05.2021**
(21) Application number: 15195551.5
(22) Date of filing: 20.11.2015
(51) Int. Cl.: H03K 17/082, H03K 17/16

(54) **SOLID STATE POWER CONTROLLER**
FESTKÖRPERLEISTUNGSREGLER
COMMANDE DE PUISSANCE A L'ETAT SOLIDE

(30) Priority: 21.11.2014 DE 102014117051
(43) Date of publication of application: 25.05.2016
(73) Proprietor: HS Elektronik Systeme GmbH, 86720 Noerdlingen (DE)
(72) Inventor: BRANTL, Peter, 86742 Fremdingen (DE); LAMMERER, Fritz, 83026 Rosenheim (DE); SEIDEL, Rainer J., 86874 Tussenhausen (DE); MAIER, Matthias, 86757 Wallerstein (DE)
(74) Representative: Schmitt-Nilson Schraud Waibel Wohlfrom Patentanwälte Partnerschaft mbB

(56) References cited:
- EP-A1- 0 833 449
- EP-A2- 0 902 537

## Description

The present invention relates to a solid state power controller (in the following referred to as SSPC).

Vehicles, such as aircraft, typically utilise one or more power distribution units to distribute power from a primary power source to various vehicle systems. A power distribution unit typically includes at least one electronic switch, such as a FET, and electronic circuitry that provides wiring protection. The electronic switch and circuitry are usually build in semiconductor technology and therefore referred to as a solid state power controller ("SSPC"). SSPC's have found widespread use because of their desirable status capability, reliability, and packaging density. SSPCs are gaining acceptance as a modern alternative to the combination of conventional electromechanical relays and circuit breakers for commercial aircraft power distribution due to their high reliability, "soft" switching characteristics, fast response time, and ability to facilitate advanced load management and other aircraft functions.

While SSPCs with current rating under 15 A have been widely utilised in aircraft secondary distribution systems, power dissipation, voltage drop, and leakage current associated with solid state power switching devices pose challenges for using SSPCs in high voltage applications of aircraft primary distribution systems with higher current ratings.

A typical SSPC generally comprises a power section including at least one solid state switching device (SSSD) which performs the primary power ON/OFF switching, and at least one control section, which is responsible for SSSD ON/OFF control and feeder wire protection. A typical power distribution unit may include hundreds or thousands of SSPCs.

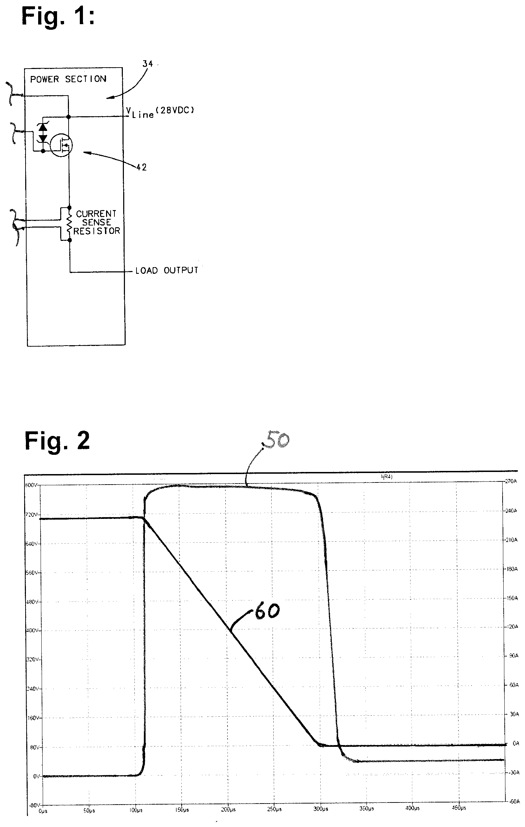

SSPCs are used to switch and regulate current on ohmic, capacitive and inductive loads. They are also used to absorb inductive energy when switching an inductive load "OFF". The SSSD is protected by a so-called clamping mode, which involves setting the voltage over the SSSD at a specific maximum voltage level. When switching an inductive load "OFF", linear mode of the SSSD is used to absorb the energy that is stored in the inductance. To that effect, the SSSD operates in linear mode for a short time after switching the inductive load to "OFF" (depending on the load, inductive energy, clamping voltage) to absorb the energy from the inductance of the load that has been switched to "OFF". Clamping results in limiting the voltage over the SSSD to a specific constant clamping voltage while discharging the load inductance, using the SSSD's linear mode. Atypical example is shown in Figs. 1 and 2. Fig. 1 shows an example SSPC circuit inlcuding a power section 34 controlled by a logic section (not shown). The power section 34 comprises a FET 42 for switching line voltage VLine applied to a line input of the FET 42 to "ON/OFF" with respect to a load output of the SSPC. The power section 34 includes a clamping circuit made up with two antiseriell Z-diodes connecting the line input to the gate terminal of the FET 42. Operation of the FET 42 is controlled by the logic section via control terminals for the source, gate and drain of the FET 42, as indicated on the left side of Fig. 1. Fig. 2 shows the transient current (as indicated by 60) occurring when the FET 42 is operated in linear mode during switch-off with an SSPC of inductive loads at a constant clamping voltage. The constant clamping voltage is apparent from the constant voltage drop 50 across the FET 42 as shown in Fig. 2, and is adjusted by the break through voltage of the Z-diode. As shown in Fig. 2, the transient current 60 occuring while operating the FET 42 in linear mode during the switching off operation declines linearly from a maximum current value to zero.

Transient currents occurring in the SSSD when switching an SSPC to "ON" or "OFF" lead to thermal stress on the SSSD.

EP 0 833 449 A2 discloses a power output stage according to the preamble of claim 1.

It is desirable to have an SSPC design which allows to suppress thermal stress onto the SSSD by transient currents during switching to "ON" or "OFF" more effectively, particularly when an inductive load is switched to "OFF".

Accordingly, one embodiment provides a solid state power controller as claimed in claim 1.

Another embodiment provides a method for switching a solid state power controller as claimed in claim 9.

Particular embodiments will now be described, by way of example only, with reference to the drawings.
Fig. 1 is a simplified circuit diagram of a standard SSPC;
Fig. 2 is a diagram showing the voltage drop across an SSSD of the SSPC of Fig. 1 during a switching OFF operation with a constant clamping voltage, as well as the transient current occuring during the switching OFF operation;
Fig. 3 is a simplified circuit diagram of an SSPC according to an embodiment of the present invention;
Fig. 4 is a diagram showing the voltage drop across an SSSD of the SSPC of Fig. 3 during a switching OFF operation with a reduced clamping voltage, as well as the transient current occuring during the switching OFF operation.

The standard SSPC as shown in Fig. 1, as well the characteristics of voltage drop over the SSSD and transient current over time during a switching OFF operation of such standard SSPC, have been described above, as far as relevant to the present invention. Reference is made to the description above.

Fig. 2 shows that during switch-off with an SSPC 34 of inductive loads, at a constant clamping voltage over the FET 42 of the SSPC the transient current 60 occuring during the switching OFF operation when the FET operates in linear mode declines from a maximum value at the start of the switching operation to zero. A consequence of such characteristic is that the maximum energy per second to be absorbed is at the start of the switching to OFF operation and thermal stress onto the FET 42 is maximum at that time.

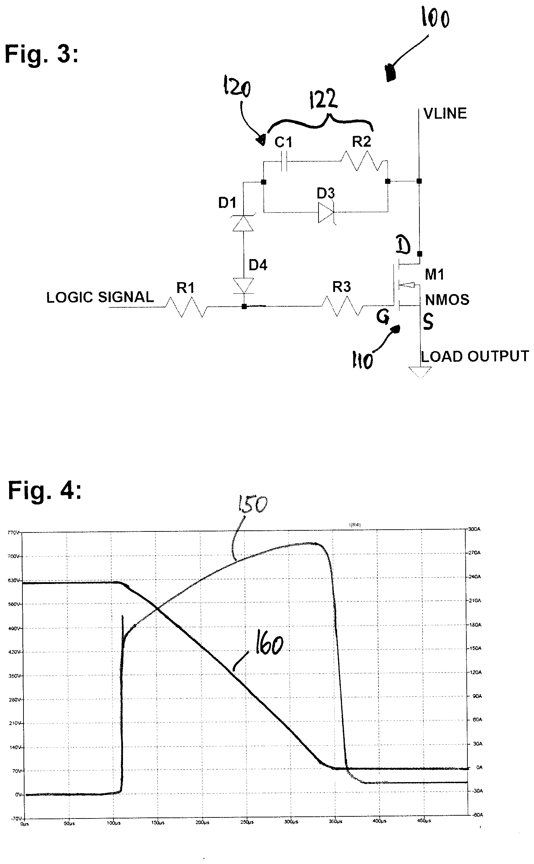

Fig. 3 shows an embodiment of an SSPC 100 as suggested herein. Fig. 3 only shows the power section of the SSPC 100, as far as relevant ot the present invention. Other parts of the SSPC 100 are not shown for sake of brevity. Particularly, SSPC 100 also will include a control section or logic section for controlling ON/OFF operation of the SSPC 100 which is not shown in Fig. 3. Moreover, Fig. 3 only shows those components of the power section of SSPC 100 having relevance for explaining the particular function of the clamping circuit as suggested herein, it be understood that usually further components will be included in practical realizations.

SSPC 100 includes an SSSD switching device 110 in the configuration of a SiC-MOSFET (metal oxide semiconductor field effect transistor), designated by M1. The SiC-MOSFET transistor is made in NMOS technology. Other configurations are conceivable for the SSSD switching device 110 as well, e.g. any other kind of switching devices or transistors based on SiC technology. Adjusting a clamping voltage time dependent as suggested herein may be beneficial for other types of SSSD's as well, particularly for Si based switching devices or transistors like MOSFET's or IGBT's. Particularly, SiC FET's have turned out to be particularly sensitive with respect to thermal loads induced by temperatures increasing above a nominal temperature.

The SSSD 110 includes a first output terminal or line input (in the MOSFET of Fig. 3: source S), a second output terminal or load output (the MOSFET of Fig. 3: drain D), and a control terminal (in the MOSFET of Fig. 3: gate G). Depending on a control voltage applied to control terminal (gate G), a conductive channel between line input (drain D) and load output (source S) will be open (ON condition) or closed (OFF condition). Drain D of the SSSD 110 is connected to line input and therefore has the electric potentialVLINE. Source S of the SSSD 110 is connected to LOAD OUTPUT. Gate G is connected to a logic section of the SSPC 100 via a first resistor R1 for controlling electrical potential of gate G (the logic section of the SSPC 100 is not shown in Fig. 3). Depending on the electric potential of gate G, the source-drain channel of the SSSD 110 will be conductive, thereby connecting line input VLINE to LOAD OUTPUT ("ON" condition of the SSSD), or non-conductive, thereby separating line input from LOAD OUTPUT ("OFF" condition of the SSSD). In OFF condition of the SSSD, LOAD OUTPUT will be at ground potential. When operating in the linear operation mode, the line input-load output channel (source-drain channel) of the SSSD 110 will be conductive, but has an electrical resistance sufficient to dissipate a transient current flowing in the SSSD 110 after the start of a switching OFF operation, e.g. in case of an SSPC 100 with inductive load. First resistor R1 is a conditioning resistor to ensure that the control signal received by the control terminal (gate G) is suitable to control the SSSD 110, e.g. with respect to limiting a charging/discharging current due to an inherent capacity of the control terminal (gate G).
The SSPC 100 according to the embodiment of Fig. 3 includes a clamping circuit 120 basically made up with two Z-diodes D1 and D3 connected in series to each other. Z-diodes D1 and D3 are connected in between the line input terminal (in Fig. 3, drain D) of SSSD 110 and the control terminal (in Fig. 3: gate G) of SSSD 110. The sum of the break through voltages of the Z-diodes D1 and 3 defines a clamping voltage, i.e. the break through voltages of the Z-diodes D1 and D3 are chosen such that their sum is well below a critical break through voltage for the source-drain channel of the SSSD 110. Thereby, the maximum voltage drop across the source-drain channel of the SSSD 110 will be restricted to the sum of the break through voltages of the two Z-diodes D1 and D3. Further Z-diodes may be added in series to first and second Z-diodes D1, D3, in order to obtain a sufficiently high clamping voltage as desired.

Further, there is a third diode D4 connected in series to the first and second Z-diodes D1 and D3. The third diode D4 is a rectifier diode which is oriented anti serial with respect to first and second Z-diodes D1 and D2, i..e. the third diode D4 is oriented in forward direction with respect to a current flowing from the line input terminal (drain D) to the control terminal (gate G) of SSSD 110, and in blocking direction with regard to a negative Voltage VLINE, or in case of a short connection of a positive control input at the control terminal (gate G) via the line input-load output path (drain-to-source path) of the SSSD 110. Third diode D4 may be any form of diode as known in the art. Particularly useful are Schottky diodes, as well as TVS diodes or Z diodes having a sufficiently high break through voltage to suppress a short circuit. Such diodes as mentioned before have proven to be beneficial under low operating temperatures because of their fast switching characteristics when operated in forward direction. In case less stringent switching characteristics in forward direction are required (e.g. because of higher operating temperatures), third diode may be a normal rectifier diode connected in blocking direction with respect to a positive potential at the control terminal (gate G).

Without any further measures, first and second Z-diodes D1 and D3 will clamp the voltage across the SSSD 110 to the clamping voltage (sum of the break through voltages of the Z-diodes D1 and D3). In case a voltage larger than the clamping voltage is applied to line input of the SSSD 110, the Z-Diodes D1 and D3 will become conductive thereby applying an electrical potential to gate terminal G for switching SSSD 110 into the ON condition linear or clamping mode.

In the embodiment shown in Fig. 3, clamping circuit 120 inlcudes a time variable clamping member 122 which is connected in parallel to one of the two Z diodes D3 of the clamping circuit 120. In Fig. 3, time variable clamping member 122 is formed with capacitor C1 connected in series to resistor R2. Capacitor C1 and resistor R2 are connected in parallel to the second Z diode D3 located on the side of line input (drain D) of the SSSD 110. Thereby, the first Z-diode D1 and the time variable clamping member 122 form an electric path connected in between the control terminal (gate G) and line input (drain D) of the SSSD 110 (where with the MOSFET of Fig. 3, drain D forms the line input of SSSD 110). This electric path provides for a time dependent voltage feedback to the control terminal (gate G) of the SSSD 110 at the start of a switching OFF operation of the SSSD 110. As soon as voltage applied to line input will be larger than the break through voltage of the first Z-diode D1, the additional electric path provided by Z-diode D1 and time variable clamping member 122 provides for an additional clamping path which clamps the voltage over the SSSD 110 (i.e. the voltage drop between line input or drain D and load output or source S of the SSSD) to a time variable clamping voltage defined by the break through voltage of the first Z-diode and the charging state of the capacitor C1 and the voltage drop at R2. Once the capacitor C1 is fully charged, the clamping voltage will be defined by the sum of the break through voltages of the Z-diodes D1 and D3.

The charging time for capacitor C1 can be adjusted as needed by the resistance of resistors R1 and R2. The voltage drop 150 across the SSSD 110 (corresponding to the time dependent clamping voltage) and transient current 160 resulting during a switching OFF operation for the SSPC 100 of Fig. 3 is shown in Fig. 4. As can be seen, the resulting voltage drop 150 across the SSSD 110 (and thereby also the clamping voltage) starts at a small value (about 450 V in Fig. 4) defined by the break through voltage of the first Z-diode D1 and the voltage drop at resistor R2. Depending on the charging state of capacitor C1 the clamping voltage increases gradually until a maximum value of the voltage drop 150 across the SSSD 110 is reached (about 730 V in Fig. 4). The voltage drop 150 across the SSSD 110 at the start of the switching OFF operation corresponds to a value of the clamping voltage significantly smaller than the maximum clamping voltage, as defined by the sum of the break through voltages of the first and second Z-diodes D1 and D3 (this value is reached at the end of the transition period after around 340 µs). In Fig. 4, the maximum voltage drop 150 is reached roughly at the same time the transient current 160 has been declined to zero.

The values of the capacitance of capacitor C1 and resistance of resistors R1 and R2 have been adjusted such as to fulfil the following conditions: (i) the maximum of the clamping voltage 150 is reached at the end of the transition period during which the transient current 160 resulting from inductive loads in the SSPC 110 declines to zero; and (ii) the clamping voltage increases with a rate in the same order of magnitude as the transient current 160 declines (or even with a rate corresponding to the same rate as the transient current 160 declines). The break through voltage of the first diode D1 is selected such that the starting value of the clamping voltage is at a level to avoid a thermal load peak in the SSSD 110 at the start of the clamping procedure.

In the embodiment shown in Fig. 3, provision of the additional time dependent clamping member 122 allows for more equally distributing the amount of energy per time to be absorbed by the SSSD 110 during a clamping procedure following a switching OFF operation of the SSSD 110. Particularly, the amount of energy per time to be absorbed immediately at the start of a switching OFF operation of the SSSD 110 can be reduced. Thereby, a thermal stress peak at beginning of the switch-off clamping phase of the SSSD 110 is avoided. It has turned out that particularly for SiC based SSSD's 110, e.g. SiC-MOSFET, aging effects can be massively reduced using the clamping circuit 120 described herein. As a result, the maximum energy absorption capability of an SSSD (particularly a power transistor) in linear mode can be improved. In case maximum energy absorption capability of the SSSD 110 would be sufficient, it is possible to reduce the transition period of the SSSD, i.e the time during which dissipation of a transient current is required by adjusting the clamping voltage during the transition period such that energy dissipation in the SSSD 110 is always close to, but smaller than, the maximum energy absorption capability. This helps to improve the switching time.

Particular embodiments as described above may include: A solid state power controller (SSPC), comprising at least one solid state switching device (SSSD) having a line input and a load output, the solid state switching device configured to switch an electrical voltage applied to the line input to "ON" or "OFF" with respect to the load output, and a clamping circuit configured to clamp a voltage drop across the line input and load output of the solid state switching device to a predetermined clamping voltage. The solid state power controller is configured to temporarily reduce the clamping voltage during an "OFF" switching operation in which the solid state switching device is switched to "OFF" with respect to the load output.

Normally, during switch-off with an SSPC of inductive loads, at a constant clamping voltage value over the SSPC the transient current declines from maximum to zero. Hence, when the SSSD is operated in linear mode during a transition period to dissipate residual electric energy, the maximum energy per second to be absorbed by the SSSD occurs at the beginning of the clamping procedure. Therefore, the switching element(s) (SSSD) used in the SSPC (usually power transistors like field effect transistors (FET) or insulated gate bipolar transistors (IGBT)) is/are subject to a thermal stress during the switching OFF operation. Thermal stress peaks at the start of the switching operation and declines thereafter. The inventors have found out that such maximum thermal stress at the beginning of the switching OFF operation leads to limitation of the switching capability in terms of current and inductance, and also is a major factor limiting useful lifetime of the SSSD. According to the embodiments disclosed herein, maximum thermal stress to the SSSD during the switching OFF operation can be reduced, as the suggested temporary reduction of the clamping voltage during the transition period leads to lower electrical power being associated with the transient current to be absorbed in the SSSD during the switching OFF operation, particularly at the beginning of the clamping procedure, when the SSSD is operated in linear mode to dissipate any residual energy from inductive loads. As a result, the amount of energy per time to be absorbed in the SSSD can be adjusted according to the maximum power absorption capability of a SSSD operated in linear mode.

The clamping circuit may be configured to reduce the clamping voltage during transition period in which the solid state switching device is operated in linear mode such as to allow a transient current to flow in the solid state switching device in a time dependent manner. Therefore, the clamping voltage may be adjusted variably throughout the transition period.

According to particular embodiments described herein, the clamping voltage is reduced based on the value of a transient current in the SSSD during a clamping procedure occurring when a solid state switching device (SSSD) is switched to OFF. Thereby, a thermal stress peak at the start of the switching OFF operation can be suppressed, as the suggested reduction of the clamping voltage leads to lower electrical energy being associated with the transient current in the solid state switching device at the start of the switching OFF operation when the solid state switching device is operated in linear mode to dissipate any residual energy from inductive loads. As a result, the amount of energy per time (i.e. power) to be absorbed by a solid state switching device (SSSD) operated in linear mode may be adjusted such as to be close to, but always smaller than the maximum energy/time absorption capability of the solid state switching device .Therefore, during the transition period, i.e the time during which dissipation of a transient current is required, the SSSD may be operated close to a given maximum energy/time absorption capability thereby improving the switching time of the SSSD.

Further embodiments may include any of the following optional features, alone or in combination:
The clamping circuit may be configured to reduce the clamping voltage to a minimum a value but significant higher than VLINE at the start of the transition period. It is to be expected that the transient current will be maximum at the start of the transition period. Further, the clamping circuit may be configured to increase the clamping voltage from the minimum value to the predetermined value at the end of the transition period. Thereby, the clamping circuit may include a time dependent clamping member allowing for more equally distributing the amount of energy per second to be absorbed by the SSSD during a switching OFF operation.

It has turned out that particularly for SSSD's based on SiC-MOSFET technology aging effects can be massively reduced using the clamping circuit described herein. As a result, the maximum energy absorption capability of an SSSD (particularly a power transistor) in linear mode can be improved. In case an increase of the maximum energy absorption capability is not required, it is possible to reduce the transition period of the SSSD, i.e the time during which dissipation of a transient current is required. This helps to improve the switching time.

In particular embodiments, the clamping circuit may be configured to increase the clamping voltage from the minimum value according to a decrease rate of the transient current flowing in the solid power switching device during the transition period. It may be conceivable to adjust the increase rate of the clamping voltage dependent on the decrease rate of the transient current flowing in the solid power switching device. Then, the electrical energy to be dissipated by the SSSD during the transition time may be distributed more equally over the transition time, i.e. at each time during the transition period approximately the same power will have to be dissipated by the SSSD. This allows to suppress thermal stress on the SSSD, and at the same time allows to improve switching characteristics (i.e. to reduce the transition period required for energy dissipation).

It is possible to set the transition period to a predetermined duration. Then, the increase rate of the clamping voltage may be adjusted accordingly.

The SSSD may comprise a control terminal and the clamping circuit may be configured to provide a voltage feedback to the control terminal of solid state switching device. The voltage feedback may be time dependent.

The SSSD may comprise a field effect transistor, e.g. a metal oxide semiconductor field effect transistor (MOSFET), as a basic solid state component for building up the solid state switching device. With a FET, the first output terminal will be a drain, the second output terminal will be source, and the control terminal will be gate. Drain may be the line input and source may be the output load. A field effect transistor features easy control. Moreover, MOSFETs have a bi-directional conduction characteristics, a resistive conduction nature, and a positive temperature coefficient. To increase the current carrying capability and reduce the voltage drop or power dissipation, the SSSD may comprise multiple MOSFETs generally connected in parallel.

The field effect transistor may comprise a SiC field effect transistor as a basic solid state component for building up the solid state switching device. SiC based SSSDs can be operated at elevated temperatures up to 175°C Junction Temperature and for switching high line input voltages up to 1200 V.

The SSSD may be used for switching DC loads as well as AC loads. Typical line input voltages VLINE may inlcude 115 VAC; 230 VAC; 28 VDC (as shown in Fig. 3); or 270 VDC. Maximum currents in the load circuit to be switched may include 5 A; 10 A; 15 A; and may be as high as 45 A. The suggested temporary reduction of the clamping voltage during the switching to OFF process, as suggested herein, is particularly useful in situation where the voltage and/or current settings are such that the SSSD has to be operated under conditions close to its safe operation limits.

The time dependent clamping voltage may be generated using passive components, i.e. withouth the use of any active controller or processor. For example, the clamping circuit may include a time dependent clamping member made up with passive components, like capacitors and resistors. In one example, the clamping circuit may comprise a Z diode, a capacitor and a resistor connected in series to each other between the line input of the SSSD and a control terminal of the SSSD.

The capacitor and the resistor form a time dependent clamping member of the clamping circuit providing for time dependent voltage feedback to the control terminal of the SSSD.

Further, the clamping circuit may comprise a first Z-diode and a second Z-diode connected in series to each other between the line input of the SSSD and the control terminal of the SSSD. The second Z-diode may be connected in parallel to the capacitor and the resistor between the line input of the SSSD and the first Z-diode. Thus, the second Z-diode is connected in parallel to the time dependent clamping member. In such configuration, a time dependent clamping voltage may be realized at a switching OFF operation of the SSSD by charging the capacitor of the time dependent clamping member. Effective overvoltage protection is provided by the second Z-diode connected in parallel to the time dependent clamping member. As the second Z-diode is connected in series to the first Z-diode, voltage over the SSSD is restricted to the clamping voltage.

A further embodiment relates to a method for switching a solid state power controller comprising at least one solid state switching device having a line input and a load output and configured to switch an electrical voltage applied to the line input to "ON" or "OFF" with respect to the load output. The method comprises clamping the voltage drop across the line input and load output of the solid state switching device to a predetermined clamping voltage, and further comprises temporarily reducing the clamping voltage during an "OFF" switching operation in which the solid state switching device is switched to "OFF" with respect to the load output. Particularly, such method includes the step of temporarily reducing the a clamping voltage at the beginning of a clamping procedure during such OFF switching operation when the transient current flowing in the SSSD is highest. The clamping voltage is increased from the minimum value to the predetermined value at the end of the transition period; and wherein the clamping voltage is increased from the minimum value according to a decrease rate of the transient current flowing in the solid state switching device during the transition period, such that at each time during the transition period approximately the same power will have to be dissipated by the solid state switching device. Such method may include any of the additional optional features described above with respect to an SSPC.

## Claims

1. A solid state power controller (100), comprising:
at least one solid state switching device (110) having a line input (VLine) and a load output (LOAD OUTPUT), the solid state switching device (110) configured to switch an electrical voltage applied to the line input to "ON" or "OFF" with respect to the load output, and
a clamping circuit (120) configured to clamp a voltage drop (150) across the line input and load output of the solid state switching device (110) to a predetermined clamping voltage,
wherein the solid state power controller (100) is configured to temporarily reduce the clamping voltage during an "OFF" switching operation in which the solid state switching device (110) is switched to "OFF" with respect to the load output; wherein the solid state switching device (110) comprises a control terminal (G) and the clamping circuit (120) is configured to provide a time dependent voltage feedback to the control terminal (G) of solid state switching device (110);
wherein the clamping circuit (120) is configured to reduce the clamping voltage during a transition period in which the solid state switching device (110) is operated in linear mode such as to allow a transient current (160) to flow in the solid state switching device; wherein the clamping circuit (120) is configured to reduce the clamping voltage to a minimum value at the start of the transition period and increase the clamping voltage from the minimum value to the predetermined value at the end of the transition period;
**characterized in that** the clamping circuit (120) is configured to increase the clamping voltage from the minimum value according to a decrease rate of the transient current (160) flowing in the solid state switching device (110) during the transition period, such that at each time during the transition period approximately the same power will have to be dissipated by the solid state switching device (110).

2. The solid state power controller (100) according to claims 1, wherein the transition period has a predetermined duration.

3. The solid state power (100) controller according to any of claims 1 to 2, wherein the solid state switching device (110) comprises a field effect transistor, particularly a metal oxide semiconductor field effect transistor (MOSFET) as a basic solid state component for building up the solid state switching device (110).

4. The solid state power controller (100) according to claim 3, wherein the field effect transistor comprises a SiC field effect transistor as a basic solid state component for building up the solid state switching device (110).

5. The solid state power controller (100) according to any of claims 1 to 4, wherein the clamping circuit comprises a Z diode (D1), and a time dependent clamping member (122) connected in series to each other between the line input (VLine) of the solid state switching device (110) and the gate (G) of the solid state switching device (110).

6. The solid state power controller (100) according to claim 5, wherein the time dependent clamping member (122) comprises a capacitor (C1) and a resistor (R2) connected in series.

7. The solid state power controller (100) according to any of claims 1 to 6, wherein the clamping circuit (120) comprises a first Z-diode (D1) and a second Z-diode (D3) connected in series to each other between the line input (VLine) of the solid state switching device (110) and the control terminal (G) of the solid state switching device (110).

8. The solid state power controller (100) according to claim 7, wherein the second Z-diode (D3) is connected in parallel to the time dependent clamping member (122) between the line input (VLine) of the solid state switching device (110) and the first Z-diode (D1).

9. A method for switching a solid state power controller (100) comprising at least one solid state switching device (110) having a line input (VLine) and a load output (LOAD OUTPUT) and configured to switch an electrical voltage applied to the line input to "ON" or "OFF" with respect to the load output, comprising:
clamping the voltage drop (150) across the line input and load output of the solid state switching device (110) to a predetermined clamping voltage by providing a time dependent voltage feedback to a control terminal (G) of the solid state switching device (110) by a clamping circuit (120), and further comprising:
temporarily reducing the clamping voltage during an "OFF" switching operation in which the solid state switching device (110) is switched to "OFF" with respect to the load output;
reducing the clamping voltage during a transition period in which the solid state switching device (110) is operated in linear mode such as to allow a transient current (160) to flow in the solid state switching device;
wherein the clamping voltage is reduced to a minimum value at the start of the transition period and increased from the minimum value to the predetermined value at the end of the transition period; **characterized in that** the clamping voltage is increased from the minimum value according to a decrease rate of the transient current (160) flowing in the solid state switching device (110) during the transition period, such that at each time during the transition period approximately the same power will have to be dissipated by the solid state switching device (110).

## Patentansprüche

1. Festkörperleistungsregler (100), umfassend:
mindestens ein Festkörperschaltgerät (110), welches einen Leitungseingang (VLine) und einen Lastausgang (LOAD OUTPUT) aufweist, wobei das Festkörperschaltgerät (110) dazu konfiguriert ist, eine elektrische Spannung, welche an den Leitungseingang angelegt ist, bezogen auf den Lastausgang auf AN (ON) oder AUS (OFF) zu schalten, und
einen Klemmschaltkreis (120), welcher dazu konfiguriert ist, einen Spannungsabfall (150) über den Leitungseingang und Lastausgang des Festkörperschaltgeräts (110) auf eine vorbestimmte Klemmspannung zu klemmen,
wobei der Festkörperleistungsregler (100) dazu konfiguriert ist, die Klemmspannung während eines OFF-Umschaltbetriebs, in welchem das Festkörperschaltgerät (110) bezogen auf den Lastausgang auf "OFF" geschaltet ist, zeitweise zu reduzieren; wobei das Festkörperschaltgerät (110) ein Regelendgerät (G) umfasst und wobei der Klemmschaltkreis (120) dazu konfiguriert ist, eine zeitabhängige Spannungsrückkopplung an das Regelendgerät (G) des Festkörperschaltgeräts (110) bereitzustellen;
wobei der Klemmschaltkreis (120) dazu konfiguriert ist, die Klemmspannung während einer Übergangsphase zu reduzieren, in welcher das Festkörperschaltgerät (110) in einem linearen Modus betrieben wird, um einem transienten Strom (160) zu ermöglichen, in das Festkörperschaltgerät zu fließen; wobei der Klemmschaltkreis (120) dazu konfiguriert ist, die Klemmspannung zu Beginn der Übergangsphase auf einen Mindestwert zu reduzieren und die Klemmspannung am Ende der Übergangsphase von dem Mindestwert auf den vorbestimmten Wert zu erhöhen;
**dadurch gekennzeichnet, dass** der Klemmschaltkreis (120) dazu konfiguriert ist, die Klemmspannung gemäß einer Absinkgeschwindigkeit des transienten Stroms (160), welcher während der Übergangsphase in das Festkörperschaltgerät (110) fließt, von dem Mindestwert zu erhöhen, so dass während der Übergangsphase zu jeder Zeit ungefähr die gleiche Leistung durch das Festkörperschaltgerät (110) abgeführt wird.

2. Festkörperleistungsregler (100) nach Anspruch 1, wobei die Übergangsphase eine vorbestimmte Dauer aufweist.

3. Festkörperleistungsregler (100) nach einem der Ansprüche 1 bis 2, wobei das Festkörperschaltgerät (110) einen Feldeffekttransistor, insbesondere einen Metalloxid-Halbleiter-Feldeffekttransistor (MOSFET) als grundlegende Festkörperkomponente zum Aufbau des Festkörperschaltgeräts (110) umfasst.

4. Festkörperleistungsregler (100) nach Anspruch 3, wobei der Feldeffekttransistor einen SiC-Feldeffekttransistor als grundlegende Festkörperkomponente zum Aufbau des Festkörperschaltgeräts (110) umfasst.

5. Festkörperleistungsregler (100) nach einem der Ansprüche 1 bis 4, wobei der Klemmschaltkreis eine Z-Diode (D1) und ein zeitabhängiges Klemmelement (122) umfasst, welche zwischen dem Leitungseingang (VLine) des Festkörperschaltgeräts (110) und dem Gate (G) des Festkörperschaltgeräts (110) in Reihe zueinander verbunden sind.

6. Festkörperleistungsregler (100) nach Anspruch 5, wobei das zeitabhängige Klemmelement (122) einen Kondensator (C1) und einen Widerstand (R2) umfasst, welche in Reihe verbunden sind.

7. Festkörperleistungsregler (100) nach einem der Ansprüche 1 bis 6, wobei der Klemmschaltkreis (120) eine erste Z-Diode (D1) und eine zweite Z-Diode (D3) umfasst, welche zwischen dem Leitungseingang (VLine) des Festkörperschaltgeräts (110) und dem Endgerät (G) des Festkörperschaltgeräts (110) in Reihe zueinander verbunden sind.

8. Festkörperleistungsregler (100) nach Anspruch 7, wobei die zweite Z-Diode (D3) parallel mit dem zeitabhängigen Klemmelement (122) zwischen dem Leitungseingang (VLine) des Festkörperschaltgeräts (110) und der ersten Z-Diode (D1) verbunden ist.

9. Verfahren zum Schalten eines Festkörperleistungsreglers (100), umfassend mindestens ein Festkörperschaltgerät (110), welches einen Leitungseingang (VLine) und einen Lastausgang (LOAD OUTPUT) umfasst und welches dazu konfiguriert ist, eine elektrische Spannung, welche an den Leitungseingang angelegt ist, bezogen auf den Lastausgang auf AN (ON) oder AUS (OFF) zu schalten, umfassend:
Klemmen des Spannungsabfalls (150) über den Leitungseingang und Lastausgang des Festkörperschaltgeräts (110) auf eine vorbestimmte Klemmspannung durch ein Bereitstellen einer zeitabhängigen Spannungsrückkopplung auf ein Regelendgerät (G) des Festkörperschaltgeräts (110) durch einen Klemmschaltkreis (120), und ferner umfassend:
zeitweises Reduzieren der Klemmspannung während eines OFF-Umschaltbetriebs, in welchem das Festkörperschaltgerät (110) bezogen auf den Lastausgang auf "OFF" geschaltet ist;
Reduzieren der Klemmspannung während einer Übergangsphase, in welcher das Festkörperschaltgerät (110) in einem linearen Modus betrieben wird, um einem transienten Strom (160) zu ermöglichen, in das Festkörperschaltgerät zu fließen; wobei die Klemmspannung zu Beginn der Übergangsphase auf einen Mindestwert reduziert wird und am Ende der Übergangsphase von dem Mindestwert auf den vorbestimmten Wert erhöht wird;
**dadurch gekennzeichnet, dass** die Klemmspannung gemäß einer Absinkgeschwindigkeit des transienten Stroms (160), welcher während der Übergangsphase in das Festkörperschaltgerät (110) fließt, von dem Mindestwert erhöht wird, so dass während der Übergangsphase zu jeder Zeit ungefähr die gleiche Leistung durch das Festkörperschaltgerät (110) abgeführt wird.

## Revendications

1. Commande de puissance à l'état solide (100), comprenant :
au moins un dispositif de commutation à l'état solide (110) ayant une entrée de ligne (VLine) et une sortie de charge (LOAD OUTPUT), le dispositif de commutation à l'état solide (110) étant conçu pour commuter une tension électrique appliquée à l'entrée de ligne sur « ON » ou « OFF » par rapport à la sortie de charge, et
un circuit de blocage (120) conçu pour bloquer une chute de tension (150) à travers l'entrée de ligne et la sortie de charge du dispositif de commutation à l'état solide (110) à une tension de blocage prédéterminée,
dans laquelle la commande de puissance à l'état solide (100) est conçue pour réduire temporairement la tension de blocage pendant une opération de commutation sur « OFF » dans laquelle le dispositif de commutation à l'état solide (110) est commuté sur « OFF » par rapport à la sortie de charge ; dans laquelle le dispositif de commutation à l'état solide (110) comprend une borne de commande (G) et le circuit de blocage (120) est conçu pour fournir une rétroaction de tension dépendant du temps à la borne de commande (G) du dispositif de commutation à l'état solide (110) ;
dans laquelle le circuit de blocage (120) est conçu pour réduire la tension de blocage pendant une période de transition au cours de laquelle le dispositif de commutation à l'état solide (110) fonctionne en mode linéaire de manière à permettre à un courant transitoire (160) de circuler dans le dispositif de commutation à l'état solide ; dans laquelle le circuit de blocage (120) est conçu pour réduire la tension de blocage à une valeur minimale au début de la période de transition et pour augmenter la tension de blocage de la valeur minimale à la valeur prédéterminée à la fin de la période de transition ;
**caractérisée en ce que** le circuit de blocage (120) est conçu pour augmenter la tension de blocage à partir de la valeur minimale en fonction d'une vitesse de décroissance du courant transitoire (160) circulant dans le dispositif de commutation à l'état solide (110) pendant la période de transition, de sorte qu'à chaque instant pendant la période de transition, environ la même puissance électrique devra être dissipée par le dispositif de commutation à l'état solide (110).

2. Commande de puissance à l'état solide (100) selon la revendication 1, dans laquelle la période de transition a une durée prédéterminée.

3. Commande de puissance à l'état solide (100) selon l'une quelconque des revendications 1 et 2, dans laquelle le dispositif de commutation à l'état solide (110) comprend un transistor à effet de champ, en particulier un transistor à effet de champ métal-oxyde-semiconducteur (MOSFET) en tant que composant à l'état solide de base pour réaliser le dispositif de commutation à l'état solide (110).

4. Commande de puissance à l'état solide (100) selon la revendication 3, dans laquelle le transistor à effet de champ comprend un transistor à effet de champ SiC en tant que composant à l'état solide de base pour réaliser le dispositif de commutation à l'état solide (110).

5. Commande de puissance à l'état solide (100) selon l'une quelconque des revendications 1 à 4, dans laquelle le circuit de blocage comprend une diode Z (D1) et un élément de blocage dépendant du temps (122) connectés en série l'un à l'autre entre l'entrée de ligne (VLine) du dispositif de commutation à l'état solide (110) et la grille (G) du dispositif de commutation à l'état solide (110).

6. Commande de puissance à l'état solide (100) selon la revendication 5, dans laquelle l'élément de blocage dépendant du temps (122) comprend un condensateur (C1) et une résistance (R2) connectés en série.

7. Commande de puissance à l'état solide (100) selon l'une quelconque des revendications 1 à 6, dans laquelle le circuit de blocage (120) comprend une première diode Z (D1) et une deuxième diode Z (D3) connectées en série l'une à l'autre entre l'entrée de ligne (VLine) du dispositif de commutation à l'état solide (110) et la borne de commande (G) du dispositif de commutation à l'état solide (110).

8. Commande de puissance à l'état solide (100) selon la revendication 7, dans laquelle la deuxième diode Z (D3) est connectée en parallèle à l'élément de blocage dépendant du temps (122) entre l'entrée de ligne (VLine) du dispositif de commutation à l'état solide (110) et la première diode Z (D1).

9. Procédé de commutation d'une commande de puissance à l'état solide (100) comprenant au moins un dispositif de commutation à l'état solide (110) ayant une entrée de ligne (VLine) et une sortie de charge (LOAD OUTPUT) et conçu pour commuter une tension électrique appliquée à l'entrée de ligne sur « ON » ou « OFF » par rapport à la sortie de charge, comprenant :
le blocage de la chute de tension (150) à travers l'entrée de ligne et la sortie de charge du dispositif de commutation à l'état solide (110) à une tension de blocage prédéterminée en fournissant une rétroaction de tension dépendant du temps à une borne de commande (G) du dispositif de commutation à l'état solide (110) par un circuit de blocage (120), et comprenant en outre :
la réduction temporaire de la tension de blocage pendant une opération de commutation sur « OFF » dans laquelle le dispositif de commutation à l'état solide (110) est commuté sur « OFF » par rapport à la sortie de charge ;
la réduction de la tension de blocage pendant une période de transition au cours de laquelle le dispositif de commutation à l'état solide (110) fonctionne en mode linéaire de manière à permettre à un courant transitoire (160) de circuler dans le dispositif de commutation à l'état solide ; dans lequel la tension de blocage est réduite à une valeur minimale au début de la période de transition et augmente de la valeur minimale à la valeur prédéterminée à la fin de la période de transition ; **caractérisé en ce que** la tension de blocage augmente à partir de la valeur minimale en fonction d'une vitesse de décroissance du courant transitoire (160) circulant dans le dispositif de commutation à l'état solide (110) pendant la période de transition, de sorte qu'à chaque instant pendant la période de transition, environ la même puissance électrique devra être dissipée par le dispositif de commutation à l'état solide (110).
